Europäisches Patentamt

European Patent Office

Office européen des brevets

(11) Publication number: **0 461 766 A2**

# EUROPEAN PATENT APPLICATION

(21) Application number: 91304517.5

(22) Date of filing: **20.05.91**

(51) Int. Cl.5: **H01L 21/20**, H01L 29/205, H01S 3/19

(30) Priority: **12.06.90 US 536692**

(43) Date of publication of application:
**18.12.91 Bulletin 91/51**

(84) Designated Contracting States:
**DE FR GB NL SE**

(71) Applicant: **AMOCO CORPORATION**
**200 East Randolph Drive**
**Chicago Illinois 60601(US)**

(72) Inventor: **Bulman, Gary Eugene**
**1170 Giese Road**
**Batavia, Illinois 60510(US)**
Inventor: **Burnham, Robert Danner**
**307 Arboretum Circle**
**Wheaton, Illinois 60187(US)**

(74) Representative: **Lewin, John Harvey et al**
**ELKINGTON AND FIFE Prospect House, 8**
**Pembroke Road**
**Sevenoaks, Kent, TN13 1XR(GB)**

(54) Silicon-doped In y Ga 1-y As laser.

(57) Silicon-doped $In_yGa_{1-y}As$ can be used as the lasant material of a laser diode and can be substantially lattice-matched to either GaAs or $Al_xGa_{1-x}As$ where $0<X\leq1$. The wavelength of output radiation from such a laser diode can be positioned within the range from about 880 to about 1100 nm through appropriate selection of the silicon and indium concentrations.

EP 0 461 766 A2

Field Of The Invention

This invention relates to the use of silicon-doped $In_yGa_{1-y}$ As as the active medium of a solid state laser. More particularly, it relates to the use of this material as the active layer of a multilayer laser diode.

Background Of The Invention

A laser is a device which has the ability to produce monochromatic, coherent light through the stimulated emission of photons from atoms, molecules or ions of an active medium or lasant material which have typically been excited from a ground state to a higher energy level by an input of energy. Such a device contains an optical cavity or resonator which is defined by highly reflecting surfaces which form a closed round trip path for light, and the active medium is contained within the optical cavity.

If a population inversion is created by excitation of the active medium, the spontaneous emission of a photon from an excited atom, molecule or ion undergoing transition to a lower energy state can stimulate the emission of photons of substantially identical energy from other excited atoms, molecules or ions. As a consequence, the initial photon creates a cascade of photons between the reflecting surfaces of the optical cavity which are of substantially identical energy and exactly in phase. A portion of this cascade of photons is then discharged out of the optical cavity, for example, by transmission through one or more of the reflecting surfaces of the cavity. These discharged photons constitute the laser output.

Excitation of the active medium of a laser can be accomplished by a variety of methods. However, the most common methods are optical pumping, use of an electrical discharge, and the passage of an electric current through the p-n junction of a semiconductor laser.

Semiconductor lasers contain a p-n junction which forms a diode, and this junction functions as the active medium of the laser. Such devices are also referred to as laser diodes. The efficiency of such lasers in converting electrical power to output radiation is relatively high and, for example, can be in excess of 40 percent.

A variety of optoelectronic devices, such as laser diodes, are comprised of a plurality of crystalline semiconductor layers which have an epitaxial relationship to each other.

The epitaxial growth of one crystal on another is possible if the two materials: (a) join along a plane boundary and share a common two-dimensional cell in this plane; and (b) have substantially the same unit cell dimension [hereinafter referred to as the "lattice constant"] $a_o$ and/or angular orientation $\theta$ for equal cell edge lengths. Typically, epitaxial growth of one material on another will occur only if the lattice mismatch, $(\Delta a_o/\tilde{a}_o) \times 100$, is less than about 10%, where $\Delta a_o$ is the difference between the lattice constants of the two materials and $\tilde{a}_o$ is the median lattice constant of the two materials. When growth is carried out by liquid phase epitaxy, a lattice mismatch greater than about 2% will typically result in uneven nucleation on the substrate and yield polycrystalline growth.

Even though the epitaxial monocrystalline growth of one material on another is possible where the materials have slightly different lattice constants, a match of the two crystal structures at the atomic level can be achieved only if the deposited crystal is elastically strained near the interface. However, such strain can be reduced by the formation of dislocations at the interface. Accordingly, the density of these dislocations will increase as the magnitude of the lattice mismatch increases. By way of example, for a crystalline material having a simple cubic structure, the spacing between edge dislocations will be expected to be approximately equal to $\tilde{a}_o^2 \Delta a_o$, which corresponds to a linear dislocation density of about $\Delta a_o/\tilde{a}_o^2$ .

It is generally believed that long-lived optoelectronic devices, such as laser diodes, must comprise a substantially lattice-matched system. Such systems are conventionally prepared by the epitaxial growth of semiconductor layers on a substrate crystal. Unfortunately, only a limited number of suitable substrates are generally available which include InP, InAs, GaP and GaAs. As a consequence, the requirement of substantial lattice matching to the available substrates places tight constraints on the range of band gap values that are available from a semiconductor ternary system. For example, $In_xGa_{1-x}As$ is lattice-matched to InP only at the composition where x = 0.47. $Al_xGa_{1-x}As$ is an exception which is substantially lattice-matched to GaAs at all values of x between 0 and 1. However, the small mismatch that does exist between $Al_xGa_{1-x}As$ and GaAs has been shown to result in an increased threshold current for double-heterostructure laser diodes wherein a GaAs active region is bounded on both sides by a layer of $Al_xGa_{1-x}As$ [see J.C. Dyment et al., Appl. Phys. Lett., Vol.24, No.10, pp. 481-484 (May 15, 1974)]

Quaternary alloys are typically utilized in order to achieve lattice-matching to readily available substrates. For example, $In_xGa_{1-x}As_yP_{1-y}$ and $Al_xGa_{1-x}As_ySb_{1-y}$ alloys can be substantially lattice-matched to either GaAs or InP at certain values of x and y, and $Al_xGa_{1-x}As_yP_{1-y}$ can be exactly lattice matched to GaAs at certain values of x and y. In quaternary alloys, significant independent tunability in band-gap and lattice constant is possible. However, quaternary compositions have not been available for use in the preparation of lattice-matched laser diodes which exhibit satisfactory performance characteristics together with emission at a wavelength in the range from about 940 to about 1000 nm. For example, $In_xGa_{1-x}As_yP_{1-y}$ alloys can be grown substantially lattice-matched to InP over a range of band-gaps equivalent to a wavelength range of about 990 to about 1700 nm However, laser diodes fabricated from such material that emit near the 990 nm lower limit have poor performance characteristics, apparently as a consequence of poor carrier confinement [see D.Z. Garbuzov, Sov. Phys. Semicond., 18, pp. 61-65 (January 1984)].

There is currently a need for laser diodes which have satisfactory performance characteristics together with an emission wavelength in the range from about 940 to about 1000 nm. For example, such laser diodes would be valuable as a source of optical pumping radiation for solid state lasers which are based on Yb which has an absorption band at about 946 nm or Er which has an absorption band at about 980 nm. Although laser diodes have been fabricated from strained-layer $In_xGa_{1-x}As/GaAs$ systems that emit at 950 nm, the lifetime of such devices has been estimated to be only about 2500 hours at room temperature [see W. Stutius et al., Electron. Lett., Vol.24, No.24, pp. 1493-1494 (November 24, 1988)]. Similarly, devices constructed from the above-mentioned $In_xGa_{1-x}As_yP_{1-y}/InP$ systems do not have satisfactory performance characteristics.

Several investigations have been reported in the literature which relate to the use of silicon-doped GaAs as an active material for light-emitting diodes and laser diodes which produce output radiation having a wavelength longer than about 920 nm. For example, I. Ladany, J. Appl. Phys., Vol.42, No.2, pp. 654-656 (1971) has reported that the peak wavelength of silicon-doped GaAs diodes can be varied over the range from 920 to 1000 nm as a function of silicon concentration in the melt from which the diode material was grown. In addition, Rossi et al., Appl. Phys. Lett., Vol.21, No.6, pp. 287-289 (Sept. 15, 1972) have reported the pulsed room-temperature operation of double-heterostructure laser diodes over the wavelength range from 910 to 950 nm using devices which contained a p-type active region of silicon-doped GaAs.

N. V. Ganina et al., Sov. Phys. Semicond., 16, pp. 1016-1019 (September 1982), have reported the epitaxial growth of silicon-doped $In_xGa_{1-x}As$ from a saturated solution of arsenic in molten gallium through the use of forced cooling and using substrates made of n-type gallium arsenide doped with tin to n = (3-5) $\times 10^{17}$ cm$^{-3}$ and oriented in the (100) plane. The indium concentration in the melt was varied over the range from 0 to 25 at.% while the silicon content of the melt was held constant. The indium concentration in the resulting silicon-doped $In_xGa_{1-x}As$ found to be in the range $0 \leq X \leq 0.0088$. Light-emitting diodes were fabricated from the resulting structures, and an increase in the indium concentration over the range $0 \leq X \leq 0.0088$ was reported to increase the half-width of the electroluminescence band from 0.07 to 0.09 eV and shifted the luminescence maximum toward longer wavelengths. This reference does not, however, either teach or suggest: (a) the construction of a laser which comprises silicon-doped $In_xGa_{1-x}As$ as the lasant material; (b) the growth of silicon-doped $In_xGa_{1-x}As$ on any substrate other than GaAs; or (c) that silicon-doped $In_xGa_{1-x}As$ can be substantially lattice-matched to either GaAs or $Al_xGa_{1-x}As$ by appropriate selection of the silicon and indium concentrations in the composition.

Summary Of The Invention

For certain applications, such as for pumping Yb, Er-doped infra-red-to-visible upconverting phosphors and for pumping solid state lasers which are based on Yb or Er, there is a need for a laser which has an emission wavelength in the range from about 880 to about 1100 nm. We have found that such a laser can be constructed through the use of an active medium which is comprised of silicon-doped $In_yGa_{1-y}As$. We have also found that such a material can be used as the active medium of a laser diode and can be substantially lattice-matched to either GaAs or $Al_xGa_{1-x}As$.

One embodiment of the invention is a composition of matter comprising crystalline silicon-doped $In_yGa_{1-y}As$ wherein y is a number in the range from about 0.0001 to about 0.02; the amount of silicon is in the range from about 0.05 to about 5 atomic percent based on the sum of Ga, Si and In; and the amounts of indium and silicon are effective to substantially lattice match said silicon-doped $In_yGa_{1-y}As$ to $Al_xGa_{1-x}As$ where $0 < X \leq 1$ and the lattice mismatch is less than 0.1%.

Another embodiment of the invention is a composition of matter comprising a plurality of crystalline epitaxially-related semiconductor layers wherein at least one of said layers is comprised of silicon-doped $In_yGa_{1-y}As$ where y is a number in the range from about 0.0001 to about 0.02 and the amount of silicon is in the range from about 0.05 to about 5 atomic percent based on the sum of Ga, Si and In, wherein at least one of said layers is comprised of $Al_xGa_{1-x}As$ where $0 < X \leq 1$, and wherein the amounts of indium and silicon in said silicon-doped $In_yGa_{1-y}As$ are effective to substantially lattice match the silicon-doped $In_yGa_{1-y}As$ to GaAs such that the lattice mismatch is less than about 0.2%.

A further embodiment of the invention is a laser wherein the lasant material is comprised of silicon-doped $In_yGa_{1-y}As$ where y is a number in the range from about 0.0001 to about 0.02 and the amount of silicon is in the range from about 0.05 to about 5 atomic percent based on the sum of Ga, Si and In.

An object of the invention is to provide a new lasant material.

Another object of the invention is to provide an active medium for a solid state laser which can be used to produce laser radiation having a wavelength in the range from about 880 to about 1100 nm.

Another object of the invention is to provide a laser diode that has an emission wavelength in the range from about 880 to about 1100 nm.

Another object of the invention is to provide a laser diode whose active medium is substantially lattice-matched to GaAs.

A further object of the invention is to provide a laser diode whose active medium is substantially lattice-matched to $Al_xGa_{1-x}As$ where $0<X\leq1$.

A still further object of the invention is to provide a laser diode which: (a) has an output wavelength in the range from about 880 to about 1100 nm; and (b) has an active medium which is substantially lattice-matched to either GaAs or $Al_xGa_{1-x}As$ where $0<X\leq1$.

Brief Description Of The Drawings

FIG. 1 is a perspective view of a broad-area, double-heterostructure laser diode which contains a silicon-doped $In_yGa_{1-y}As$ active layer in accordance with this invention.

FIG.2 is a representation of a liquid phase epitaxy system which is suitable for use in the epitaxial growth of the silicon-doped $In_yGa_{1-y}As$ compositions of this invention.

FIG.3 is a detailed cross-sectional view of that portion of the system of FIG.2 wherein epitaxial growth is carried out.

Detailed Description Of The Invention

We have found that silicon-doped $In_yGa_{1-y}As$ is a highly satisfactory lasant material since: (a) it can be utilized to generate laser radiation of a wavelength that can be varied over the range from about 880 to about 1100 nm as a function of the silicon indium concentrations; and (b) it can be substantially lattice-matched to either GaAs or $Al_xGa_{1-x}As$ where $0<X\leq1$. Accordingly, this material can be utilized to achieve either substantial or complete lattice matching in optoelectronic devices which comprise such a material in combination with GaAs an-or $Al_xGa_{1-x}As$ where $0<X\leq1$. A highly preferred embodiment of the invention is a semiconductor device which comprises a plurality of crystalline, epitaxially-related semiconductor layers wherein at least one of the layers is comprised of silicon-doped $In_yG_{1-y}As$ and at least one of the layers is comprised of either GaAs or $Al_xGa_{1-x}As$ where $0<X\leq1$. It will be appreciated, of course, that any of these layers can be either $n^+$ or $p^+$ doped with small amounts of conventional dopants which include but are not limited to tellurium and magnesium.

In view of the fact that substantial lattice matching is possible between silicon-doped $In_yGa_{1-y}As$, GaAs and $Al_xGa_{1-x}As$, a substantially lattice-matched laser diode can be constructed from these materials. If such a device is constructed using silicon-doped $In_yGa_{1-y}As$ as the lasant material, the wavelength of output radiation from the device can be positioned within the range from about 880 to about 1100 nm through appropriate selection of the silicon and indium concentrations.

The silicon-doped $In_yGa_{1-y}As$ of this invention has a silicon concentration which is desirably in the range from about 0.05 to about 5 atomic percent and preferably in the range from about 0.5 to about 4 atomic percent based on the sum of Ga, Si and In. The indium concentration of this material is such that y is a number which is desirably in the range from about 0.0001 to about 0.02 and preferably in the range from about 0.0005 to about 0.01. It will be appreciated, of course, that y x 100 is equal to the atomic percent of In in the composition based on the sum of In and Ga present. Within these concentration ranges of silicon and indium, it is possible to substantially lattice match the silicon-doped $In_yGa_{1-y}As$ to either GaAs or $Al_xGa_{1-x}As$ where $0<X\leq1$. A highly suitable $Al_xGa_{1-x}As$ composition for use in the construction of semiconductor devices and suitable for combination with the silicon-doped $In_yGa_{1-y}As$ compositions of this invention will have a value of x in the range from about 0.2 to about 0.8.

The crystalline, silicon-doped $In_yGa_{1-y}As$ compositions of this invention can be produced by any suitable technique, for example, crystallization from a melt which is comprised of the various components of the composition. Epitaxial growth of such compositions on GaAs or $Al_xGa_{1-x}As$ substrates can be carried out by liquid phase epitaxial growth from a saturated solution of arsenic in molten gallium to which silicon and indium have been added. We have found that when a liquid phase epitaxial growth procedure is utilized,

4

substantially lattice-matched growth occurs over many but not all concentrations of indium and silicon in the melt. Although the invention is not to be so limited, we believe that a "lattice latching" effect takes place which tends to pull the composition of the crystalline growth toward a lattice-matched relationship with its substrate over a range of melt compositions. This lattice-matched relationship is, of course, developed at a growth temperature which will typically be in a range from about 800° C to about 900° C. Because of slight differences between the coefficient of thermal expansion of the silicon-doped $In_yGa_{1-y}As$ growth and that of its substrate, slight lattice mismatch may result when the resulting structure is cooled to room temperature. However, for GaAs and $Al_xGa_{1-x}As$ substrates, the mismatch resulting upon cooling is quite small, and substantially lattice-matched structures can be obtained. With respect to either GaAs or $Al_xGa_{1-x}As$ where $0<X\leq1$ and for the purposes of this invention, a substantial lattice match with silicon-doped $In_yGa_{1-y}As$ refers to a lattice mismatch of less than about 0.2%, desirably less than 0.15% preferably less than 0.1% and more preferably less than 0.05%.

In a series of experiments, multilayered semiconductor structures, which are suitable for fabrication into laser diodes, were grown by liquid phase epitaxy on a crystalline silicon-doped GaAs substrate. These structures contained the following sequential layers:

1. Silicon-doped GaAs substrate;

2. $n^+$ Tellurium-doped GaAs buffer layer (about 0.5 $\mu$m thick);

3. $n^+$ Tellurium-doped $Al_{0.4}Ga_{0.6}As$ lower cladding layer (about 1.0 $\mu$m thick);

4. Silicon-doped $In_yGa_{1-y}As$ active layer (depending on the sample, from about 0.1 $\mu M$ to about 2.0 $\mu$m thick);

5. $p^+$ Magnesium-doped $Al_{0.4}Ga_{0.6}As$ upper cladding layer (about 1.0 $\mu$m thick); and

6. $p^+$ Magnesium-doped $In_zGa_{1-z}As$ contact layer (about 0.1 $\mu$m thick wherein z is in the range from 0 to about 0.001).

In each case, the silicon-doped $In_yGa_{1-y}As$ active layer of these structures was grown from a melt wherein: (a) the melt comprised a saturated solution of arsenic in molten gallium; (b) the melt had a silicon concentration of 5 atomic percent based on the combination of silicon, indium and gallium; and (c) the indium concentration of the melt in the series of experiments was varied such that the weight ratio of indium to gallium ($W_{In}/W_{Ga}$) ranged from 0.101 to 1.63. Analytical data for the silicon-doped $In_yGa_{1-y}As$ active layers obtained in these experiments are set forth in Table I.

## TABLE I

|  |  | Properties of Silicon-Doped $In_yGa_{1-y}As$ Active Layer |  |  |
|---|---|---|---|---|
| Sample No. | $W_{In}/W_{Ga}$ of Melt | $(\Delta a_o/\bar{a}_o) \times 100$ Relative to GaAs[a] | Si Conc., Atomic %[b] | In Conc., Atomic %[b] |
| 1 | 0.101 | ≤ 0.11 | 1.5 | 0.09 |
| 2 | 0.492 | ≤ 0.11 | 2.7 | 0.2 |
| 3 | 0.588 | ≤ 0.12 |  |  |
| 4 | 0.62 | ≤ 0.12 | 2.9 | 0.3 |
| 5 | 0.732 | + 0.07 |  |  |
| 6 | 1.01 | + 0.20 | 3.0 | 0.5 |
| 7 | 1.23 | ≤ 0.11 |  |  |
| 8 | 1.30 | ≤ 0.11 | 2.1 | 0.5 |
| 9 | 1.63 | + 0.28 | 3.3 | 0.6 |

(a) Determined by double crystal x-ray diffractometry.

(b) Based on the sum of silicon, indium and gallium in the active layer using data obtained by Auger Electron Spectroscopy.

With reference to the samples described in Table I, the lattice mismatch of the $Al_{0.4}Ga_{0.6}As$ layers relative to GaAs for Sample Nos. 1, 2, 7 and 8 was found to be 0.11 and for Sample Nos. 3 and 4 was found to be 0.12. In Sample Nos. 1-4, 7 and 8, the silicon-doped $In_yGa_{1-y}As$ active layer was found to be completely lattice-matched either to the GaAs substrate or the $Al_{0.4}Ga_{0.6}As$ cladding layers. The results of double crystal diffraction experiments suggest that the silicon-doped $In_yGa_{1-y}As$ active layer was closely lattice-matched to GaAs over the entire composition range investigated.

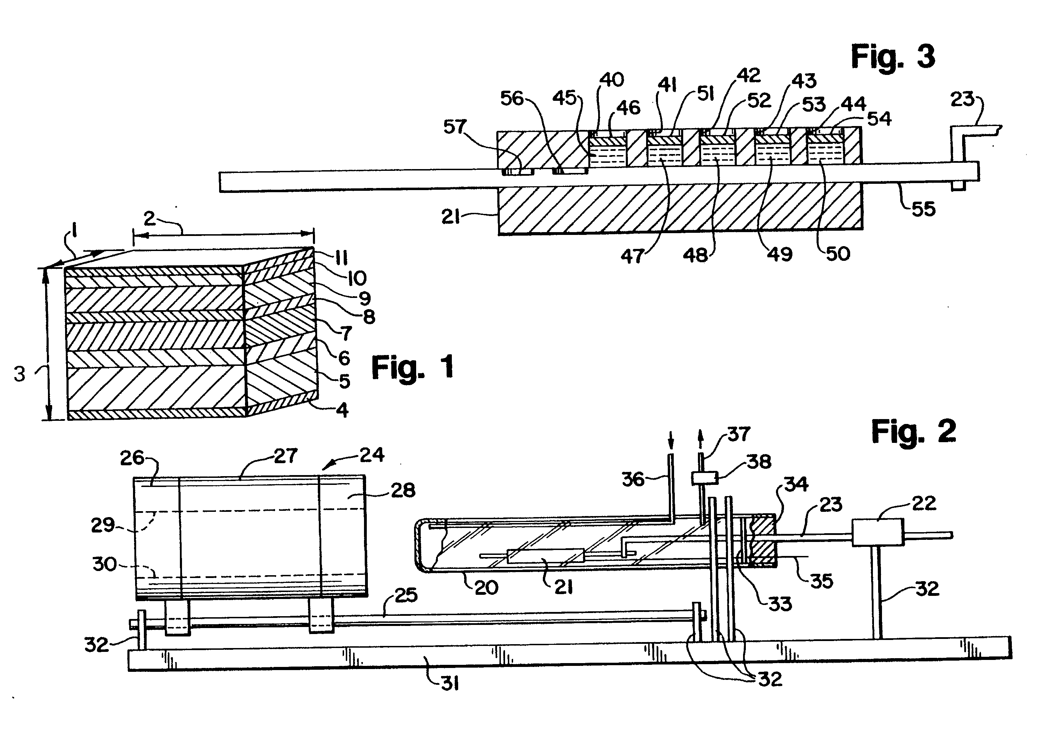

A broad-area, double-heterostructure laser diode was fabricated from a sample which was similar to Sample No.2 in Table I. FIG. 1 is a perspective view of this device. With reference to FIG. 1, the cavity length 1 was 0.25 mm and the front facet had a width 2 of 0.18 mm and a height 3 of 0.10 mm. An ohmic contact 4 composed of a ternary alloy of gold, germanium and nickel was deposited on the (100) oriented silicon-doped GaAs substrate 5. The epitaxial layers of the device consisted of n[+] tellurium-doped GaAs buffer layer 6; n[+] tellurium-doped $Al_{0.4}Ga_{0.6}As$ lower cladding layer 7; silicon-doped $In_yGa_{1-y}As$ active layer 8 which was about 0.1μm thick; p[+] magnesium-doped $Al_{0.4}Ga_{0.6}As$ upper cladding layer 9; and p[+] magnesium-doped $In_zGa_{1-z}As$ contact layer 10. Finally, an ohmic contact 11 was deposited on top of the device which consisted of an initial 10 nm thick layer of titanium adjacent to contact layer 10, an intermediate 30 nm thick layer of platinum and a final 200 nm thick layer of gold. The threshold current for the device was 3200 A/cm², and its spontaneous emission wavelength was found to peak at 964.6 nm. For comparison purposes, a laser diode was fabricated which was substantially identical except that active layer 8 was grown by liquid phase epitaxy from a melt which was indium free but otherwise the same as that used for the growth of the above-described Sample No.2. This comparison device had a similar threshold current of 2900 A/cm² but emitted light at a wavelength of only 939 nm.

We have also found that the above-described double-heterostructure laser diode can be improved by placing a thin layer of GaAs on one or, preferably, on both sides of the silicon-doped $In_yGa_{1-y}As$ active layer (such a layer of GaAs is herein referred to as a "diffusion barrier layer"). By way of specific example, such a laser diode could contain the following sequential layers:

1. Silicon-doped GaAs substrate;

2. $n^+$ Doped GaAs buffer layer;

3. $n^+$ Doped $Al_{0.4}Ga_{0.6}As$ lower cladding layer;

4. $n^+$ Doped GaAs diffusion barrier layer;

5. Silicon-doped $In_yGa_{1-y}As$ active layer;

6. $p^+$ Doped GaAs diffusion barrier layer;

7. $p^+$ Doped $Al_{0.4}Ga_{0.6}As$ upper cladding layer; and

8. $p^+$ Doped $In_zGa_{1-z}As$ contact layer (where $0 \leq Z \leq 0.02$).

Although the precise function of a diffusion barrier layer is uncertain, it is believed that, during the epitaxial growth process, such a layer serves to reduce or prevent interdiffusion between the cladding layer and the active layer which it separates.

A series of broad-area double-heterostructure laser diodes were prepared in accordance with this invention which: (a) contained a silicon-doped $In_yGa_{1-y}As$ active layer, an $n^+$ $Al_{0.4}Ga_{0.6}As$ lower cladding layer and a $p^+$ $Al_{0.4}Ga_{0.6}As$ upper cladding layer; (b) did not contain any diffusion barrier layer; and (c) were grown by liquid phase epitaxy at a temperature of about $860°C$. In this series of devices, we have found that the emission wavelength of the laser diode becomes shorter as the thickness of the silicon-doped $In_yGa_{1-y}As$ active layer is reduced in magnitude. However, interposing a thin GaAs diffusion barrier layer between the active layer and one of the cladding layers reduces this effect and also improves the device performance. For example, a 51 nm thick $n^+$ GaAs diffusion barrier layer interposed between a 60 nm thick layer and a 1 μm thick lower cladding layer resulted in an increase in the emission wavelength of the device from 937 to 945 nm and a reduction in the threshold current density from 5-6 kA/cm² to 2.5-3.5 kA/cm². Placing a diffusion barrier layer on both sides of the active layer to separate it from both upper and lower cladding layers further improves the laser diode performance and further reduces the apparent dependance of emission wavelength on thickness of the active layer.

A suitable diffusion barrier layer will desirably be quite thin and, for example, can have a thickness in the range from about 2 to about 200 nm, and preferably in the range from about 10 to about 75 nm. The diffusion barrier layer need not be doped. However, if desired, it can be either $n^+$, n, $p^+$ or p doped. Any doping should, of course, be of the same type as that of the cladding layer which is adjacent to the diffusion barrier layer. If desired, the diffusion barrier layer can be comprised of $Al_xGa_{1-x}As$ rather than GaAs where the value of x is selected so that the aluminum content is lower than that of the adjacent cladding layer.

A representation of a liquid phase epitaxy system which is suitable for use in the growth of the silicon-doped $In_yGa_{1-y}As$ compositions of this invention is shown in FIG.2. With reference to FIG.2, the system comprises a hollow fused quartz reactor 20 containing a graphite growth boat 21, a stepper motor 22 to pull mechanical linkage 23 which is attached to graphite boat 21, and 3-zone semitransparent furnace 24 which is mounted on and movable on linear track 25. Furnace 24 has three independently controllable heating zones 26, 27 and 28 and contains a heated cavity which is cylindrical in shape and indicated in cross-section by dashed lines 29 and 30. Reactor 20, stepper motor 22 and track 25 are attached to base 31 by means of supports 32. Reactor 20 is sealed at one end by means of O-ring 33 and end cap 34. A Type R thermocouple 35 and mechanical linkage 23 pass through vacuum tight fittings in cap 34. Thermocouple 35 is used to monitor the temperature of graphite boat 21 and fits inside a fused quartz sleeve (not shown) which extends from end cap 34 through a hole machined through the length of boat 21. Reactor 20 is cylindrical in shape, has an outside diameter of 75 mm and is flushed with palladium diffused hydrogen at rate of about 1 liter/minute. The hydrogen flows into reactor 20 through inlet tube 36 and is discharged from reactor 20 through vent tube 37. The water vapor content of the hydrogen discharged through vent tube 37 (a measure of the system's integrity) is measured by hygrometer 38. The 3-zone furnace 24 is controlled by three independently programmable temperature controllers (not shown). Finally, an IBM-XT computer (not shown) is attached to: (a) each of the three furnace controllers, (b) hygrometer 38, (c) a digital thermometer (not shown) attached to thermocouple 35, and (d) the controller (not shown) for stepper motor 22. Aside from initial alignment of growth boat 21, the computer is used to completely operate the system.

The liquid phase epitaxial growth of a double heterostructure of the type illustrated in FIG.1 requires five separate melts. That is to say, one each for the: (1) buffer layer, (2) lower cladding layer, (3) active layer, (4) upper cladding layer, and (5) contact layer. In a representative example involving a growth temperature of about $860°C$, melts of the following composition can be used for growth of the indicated layer (in each case, the melt comprises a saturated solution of arsenic in gallium which also contains the additives and their amounts as stated below where W refers to the weight of a component and the component is identified by a subscript):

1. Melt A ($n^+$ GaAs buffer layer)

$W_{Te}/W_{Ga} = 5.5 \times 10^{-5}$

2. Melt B ($n^+$ $Al_{0.4}Ga_{0.6}As$ lower cladding layer)

$W_{Al}/W_{Ga} = 0.00136$

3. Melt C (Si-doped $In_yGa_{1-y}As$ active layer)

$W_{In}/W_{Ga} = 0.4$

$W_{Si}/W_{Ga} = 0.026$

4. Melt D($p^+$ $Al_{0.4}Ga_{0.6}As$ upper cladding layer)

$W_{Al}/W_{Ga} = 0.00146$

$W_{Mg}/W_{Ga} = 7.5 \times 10^{-5}$

5. Melt E ($p^+$ $In_zGa_{1-z}As$ contact layer)

$W_{In}/W_{Ga} = 0.13$

$W_{Mg}/W_{Ga} = 9.0 \times 10^{-5}$

A detailed cross-sectional view of the graphite growth boat 21 is shown in FIG.3. With reference to FIG.3, boat 21 contains five wells 40-44 which are utilized to hold the melts that are required for the growth of a structure which comprises five layers of crystalline epitaxially-related semiconductor materials on a suitable substrate. Each of the wells 40-44 are rectangular in shape when viewed from the top with dimensions of 1.27 x 2.03 cm. With reference to the above defined melts A-E, the components for generating melt A 45 are loaded into well 40 and covered with a graphite cap 46. A rectangular (about 1.2 x 2.0 cm) wafer of undoped polycrystalline GaAs having a thickness of about 0.5 mm and placed at the top of melt A can be used as a convenient source of arsenic for the melt. Similarly, wells 41-44 are loaded with the components for generating melts B-E, 47-50 respectively, and covered with graphite caps 51-54, respectively. The growth boat contains a movable graphite slider 55 which is attached to mechanics linkage 23. Graphite slider 55 serves to seal the bottom of wells 40-44. In addition, graphite slider 55 contains two substrate wells 56 and 57 which are rectangular in shape when viewed from the top with dimensions of 1.52 x 2.29 cm. Well 56 is loaded with a rectangular wafer of (100) orientation GaAs, and well 57 is loaded with a rectangular wafer of (100) orientation silicon-doped GaAs which serves as the growth substrate.

After purging reactor 20 with hydrogen, furnace 24 is pulled over reactor 20, and graphite growth boat 21 is brought to a temperature of about 800°C. Furnace 24 is then removed, and slider 55 is manually positioned as illustrated in FIG.3. Furnace 24 is then pulled back over reactor 20, and the computer controls for the system are activated when the temperature of boat 21 reaches 800°C. Under computer control, boat 21 is heated to a growth temperature of about 860°C and allowed to equilibrate at that temperature for about 45 to 60 minutes before epitaxial growth is initiated.

To begin epitaxial growth, the computer used to operate the system activates a temperature ramp program that it has previously downloaded into each of the three temperature controllers that are used to operate furnace 24. A constant downward ramp rate of about 1°C/min can be used and, after the furnace begins to respond (typically about 2 min. or less), slider 55 is rapidly moved by stepper motor 22 and mechanical linkage 23 to the right (for example, at a velocity of about 2.5 cm/sec) so that well 56 in slider 55 is positioned below upper well 40. In this position, the wafer of GaAs in well 56 is in contact with melt A 45 in well 40 while the growth substrate in well 57 is still covered. The purpose of this first GaAs wafer in well 56 is to clean up the bottom of melt A 45 and decrease the saturation of the melt to a level satisfactory for growth. After a short period of time (typically about 1 min.), slider 55 is moved further to the right by stepper motor 22 and mechanical linkage 23 so that wells 56 and 57 in slider 55 are positioned under upper wells 41 and 40, respectively. In this position, the wafer of GaAs in well 56 is in contact with melt B 47 in upper well 41, and the growth substrate in well 57 is in contact with melt A 45 in well 40. At this time, the growth of the $n^+$ GaAs buffer layer begins on the growth substrate in well 57, with the thickness of the epitaxial growth being a function of the growth time and downward temperature ramp rate. Simultaneously, the wafer of GaAs in well 56 is equilibrating with melt B 47 in well 41. After an appropriate period of time, slider 55 is moved further to the right by stepper motor 22 and mechanical linkage 23 so that wells 56 and 57 in slider 55 are positioned under upper wells 42 and 41, respectively. This process is repeated until all five layers (buffer, lower cladding, active, upper cladding and contact layers) are grown. For example, the growth periods used for the buffer, lower cladding, active, upper cladding and contact layers of the Sample used for fabrication of the 964.6 nm laser diode illustrated in FIG.1 were 6.0, 15.5, 0.35, 15.5 and 0.45 min, respectively, with a downward temperature ramp rate of 0.2°C/min. After all of the layers have been grown, slider 55 is pulled so that wells 56 and 57 are positioned outside and to the right of graphite growth boat 21. Furnace 24 is then pulled off from reactor 20, and reactor 20 and its contents are allowed to cool to room temperature.

## Claims

1. A composition of matter comprising crystalline silicon-doped $In_yGa_{1-y}As$ wherein y is a number in the range from about 0.0001 to about 0.02; the amount of silicon is in the range from about 0.05 to about 5 atomic percent based on the sum of Ga, Si and In; and the amounts of indium and silicon are effective to substantially lattice match said silicon-doped $In_yGa_{1-y}As$ to $Al_xGa_{1-x}As$ where $0<X\leq1$ and the lattice mismatch is less than 0.1%.

2. The composition of claim 1 wherein the lattice mismatch is less than 0.05%.

3. A composition of matter comprising a plurality of crystalline epitaxially-related semiconductor layers wherein at least one of said layers is comprised of silicon-doped $In_yGa_{1-y}As$ where y is a number in the range from about 0.0001 to about 0.02 and the amount of silicon is in the range from about 0.05 to about 5 atomic percent based on the sum of Ga, Si and In, wherein at least one of said layers is comprised of $Al_xGa_{1-x}As$ where $0<X\leq1$, and wherein the amounts of indium and silicon in said silicon-doped $In_yGa_{1-y}As$ are effective to substantially lattice match the silicon-doped $In_yGa_{1-y}As$ to GaAs such that the lattice mismatch is less than about 0.2%.

4. The composition of claim 3 wherein said lattice mismatch is less than 0.15%.

5. A laser which comprises a solid lasant material within an optical cavity wherein the lasant material is comprised of silicon-doped $In_yGa_{1-y}As$ where y is a number in the range from about 0.0001 to about 0.02 and the amount of silicon is in the range from about 0.05 to about 5 atomic percent based on the sum of Ga, Si and In.

6. The laser of claim 5 wherein said laser is a laser diode.

7. The laser of claim 6 which is comprised of a plurality of crystalline, epitaxially-related, semiconductor layers wherein at least one of said layers is comprised of GaAs and the lasant material is comprised of at least one layer of said silicon-doped $In_yGa_{1-y}As$.

8. The laser of claim 7 wherein the amounts of indium and silicon are effective to substantially lattice match said silicon-doped $In_yGa_{1-y}As$ to said GaAs such that the lattice mismatch is less than about 0.2%.

9. The laser as set forth in claim 6 which is comprised of a plurality of crystalline, epitaxially-related semiconductor layers wherein at least one of said layers is comprised of $Al_xGa_{1-x}As$ where $0<X\leq1$ and the lasant material is comprised of at least one layer of said silicon-doped $In_yGa_{1-y}As$.

10. The laser of claim 9 wherein the amounts of indium and silicon are effective to substantially lattice match said silicon-doped $In_yGa_{1-y}As$ to said $Al_xGa_{1-x}As$ such that the lattice mismatch is less than about 0.2%.

**Fig. 3**

**Fig. 1**

**Fig. 2**

EP 0 461 766 A2